# EUROPEAN PATENT APPLICATION

(11) **EP 4 446 455 A1**
(43) Date of publication of application: **16.10.2024**
(21) Application number: 22904062.1
(22) Date of filing: 25.11.2022
(51) Int. Cl.: C23C 4/02, H01L 21/683

(54) **METAL MASK**

(30) Priority: 10.12.2021 JP 2021004723 U
(71) Applicant: NHK Spring Co., Ltd., Yokohama-shi, Kanagawa 236-0004 (JP)
(72) Inventor: YOKOYAMA, Hibiki, Yokohama-shi, Kanagawa 236-0004 (JP); FUTAKUCHIYA, Jun, Yokohama-shi, Kanagawa 236-0004 (JP); KANEDA, Noriyoshi, Yokohama-shi, Kanagawa 236-0004 (JP); SONE, Michiyoshi, Yokohama-shi, Kanagawa 236-0004 (JP); FUJII, Masahiro, Yokohama-shi, Kanagawa 236-0004 (JP); NAMBU, Takatoshi, Yokohama-shi, Kanagawa 236-0004 (JP)
(74) Representative: dompatent von Kreisler Selting Werner - Partnerschaft von Patent- und Rechtsanwälten mbB
(86) International application number: PCT/JP2022/043571
(87) International publication number: WO 2023/106131

(57) **Abstract**

The metal mask has a body having a first surface in contact with a surface of a workpiece, a second surface opposite the first surface and a third surface between the first surface and the second surface, and an eave portion continuous with the body portion and projecting outwards from the first surface, the eave portion being arranged away from the surface of the workpiece. The third surface (side surface) of the body portion of the metal mask may have a stepped portion formed of the eave portion. The third surface (side surface) of the body part has an inclined surface that extends from the first surface to the second surface and may have a structure in which the eave portion is arranged above the inclined surface.

## Description

### TECHNICAL FIELD

The present disclosure relates to the structure of a metal mask that can be used for thermal spraying on a workpiece.

### BACKGROUND ART

A technology is disclosed for spraying a ceramic insulating film onto a metal workpiece (also called "base material" or "component") in order to provide a high voltage and heat resistance (for example, Patent Literature 1).

### CITATION LIST

### PATENT LITERATURE

Patent Literature 1: Japanese Unexamined Patent Application Publication No. 2014-013874

### SUMMARY OF INVENTION

### TECHNICAL PROBLEM

Since the formation of a film by thermal spraying involves melting a material such as metal or ceramics using a heat source and injecting the molten particles into a workpiece to form a film, it is difficult to accurately separate the areas where a film is deposited from areas where no film is deposited. Therefore, it is necessary to mask the areas on the workpiece where the film is not to be deposited beforehand.

For example, masking materials such as masking tape are provided to prevent thermal spray coatings from being deposited on a part of the surface of the workpiece. However, the film deposited by the thermal spraying process is continuously deposited not only on the surface of the workpiece but also on the masking material, which causes cracks in the film when the masking material is removed, and also causes peeling at the boundary with the mask.

In view of these problems, the purpose of the present disclosure is to provide a fixture that enables easy masking when forming a film on the surface of a workpiece by thermal spraying and that does not cause damage to the film deposited on the workpiece.

### SOLUTION TO PROBLEM

A metal mask in an embodiment according to the present invention includes a body having a first surface in contact with a surface of a workpiece, a second surface opposite the first surface and a third surface between the first surface and the second surface, and an eave portion continuous from the body and projecting externally from the first surface. The eave portion is arranged away from the surface of the workpiece.

In an embodiment of the present disclosure, the third surface (side surface) pertaining to the body of the metal mask may have a stepped portion arranged to form an eave portion. The third surface (side surface) of the body may have a structure in which the eave portion is arranged above a sloping surface, with the sloping surface widening from the first surface to the second surface.

The metal mask according to an embodiment of the present disclosure may have the body and the eave portion made of metal, the body and the eave portion made of resin, or the body and the eave portion made of metal and the surface masked with resin.

### ADVANTAGEOUS EFFECTS OF INVENTION

According to an embodiment of the present disclosure, it is possible to prevent damage to the film formed by thermal spraying when the metal mask is removed from the workpiece, by providing the metal mask with an eave portion arranged away from the surface of the workpiece and not in direct contact with it.

### BRIEF DESCRIPTION OF DRAWINGS

FIG. 1A is a plan view of a metal mask according to an embodiment of the present disclosure.
FIG. 1B is a cross-sectional view of a metal mask according to an embodiment of the present disclosure.
FIG. 2A is a plan view showing a metal mask attached to a workpiece according to an embodiment of the present disclosure.
FIG. 2B is an illustration of a metal mask attached to a workpiece according to an embodiment of the present disclosure and shows an enlarged view of the region X1 shown in FIG. 2A.
FIG. 3A is a cross-sectional view of a body and an eave portion of a metal mask according to an embodiment of the present disclosure.
FIG. 3B is a cross-sectional view of a body and an eave portion of a metal mask according to an embodiment of the present disclosure.
FIG. 3C is a cross-sectional view of a body and an eave portion of a metal mask according to an embodiment of the present disclosure.
FIG. 3D is a cross-sectional view of a body and an eave portion of a metal mask according to an embodiment of the present disclosure.
FIG. 3E is a cross-sectional view of a body and an eave portion of a metal mask according to an embodiment of the present disclosure.
FIG. 3F is a cross-sectional view of a body and an eave portion of a metal mask according to an embodiment of the present disclosure.

### DESCRIPTION OF EMBODIMENTS

Hereinafter, each embodiment of the present disclosure will be described with reference to drawings and the like. However, the present disclosure may be implemented in various ways to the extent that it does not deviate from the gist thereof and shall not be construed as being limited to the description of the embodiments illustrated below.

The drawings may be represented schematically with respect to the width, thickness, shape, and the like of each portion in comparison with the actual embodiment in order to make the description clearer, but they are examples only and do not limit the interpretation of the present disclosure. In this description and the drawings, elements having functions similar to those described with reference to existing drawings may be denoted by the same reference numerals and duplicate descriptions may be omitted.

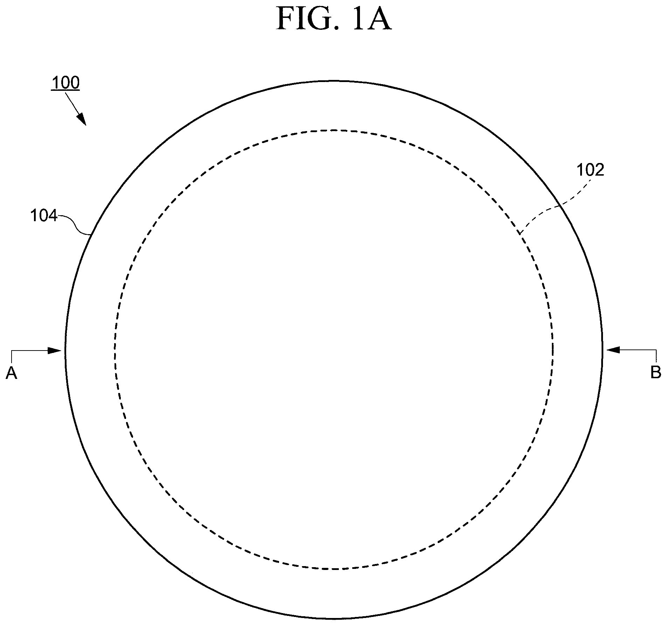

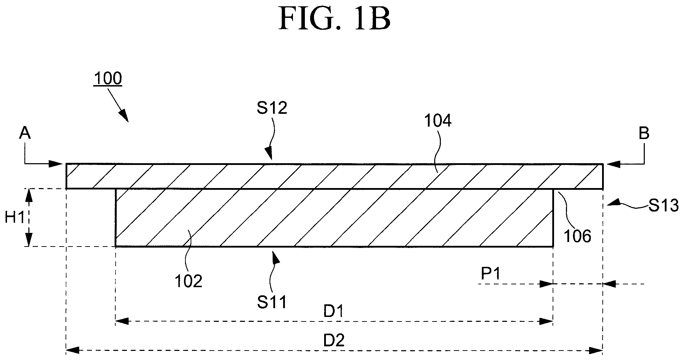

FIG. 1 shows the structure of a metal mask 100 according to an embodiment of the present disclosure. FIG. 1A shows a plan view of the metal mask 100 and FIG. 1B shows a cross-sectional view corresponding to A-B shown in the plan view. The metal mask 100 shown in FIG. 1A and FIG. 1B is a fixture used in a thermal spraying process to mask the part of a workpiece that does not form a film when a film is formed on the surface of the workpiece by thermal spraying.

The metal mask 100 has a flat (or disc-shaped) appearance and has a first surface S11 in contact with the workpiece, a second surface S12 opposite the first surface S11 and a third surface S13 between the first surface S11 and the second surface S12. The first surface S11 of the metal mask 100 corresponds to the bottom surface, the second surface S12 corresponds to the top surface and the third surface S13 corresponds to the side surface.

The metal mask 100 can be divided into configuration elements: the body 102, which mainly forms the first surface S11 and the second surface S12, and the third surface S13 (side surface), and an eave portion 104, which is arranged above the body 102 and protrudes in the width direction. The first surface S11 of the body 102 is the part in direct contact with the workpiece.

As shown in FIG. 1B, when the metal mask 100 is viewed in a cross-section, a step portion 106 is arranged on the third surface S13 (side surface), and the step portion 106 may be regarded as forming the eave portion 104. FIG. 1B shows a single step shape, but the step portion 106 may be formed by a plurality of steps.

The metal mask 100 having such an appearance is provided as an integrally molded part. The metal mask 100 may have a structure in which the body 102 and the part forming the eave portion 104 are provided as separate parts, and both parts are assembled to form a single unit.

The body 102 and the eave portion 104, which configure the metal mask 100, each have a different function. The body 102 is a portion in direct contact with the workpiece and is also the main portion that masks the workpiece with a surface to prevent the formation of a film during thermal spraying. To enable the metal mask 100 to be attached stably to the workpiece, the first surface S11 of the body 102 has a shape that enables the entire surface of the body 102 to be in contact with the workpiece. For example, when the masked surface of the workpiece is flat, the first surface S11 of the body 102 also has a flat shape. When the masked surface of the workpiece includes a step, the first surface S11 of the body 102 has a step structure formed to fit into the step of the masked surface.

The eave portion 104 has the function of adjusting a range of film deposition so that the film does not form directly on the sides of the body 102. Therefore, the eave portion 104 is preferably arranged over the entire circumference of the body 102. The eave portion 104 has a function as a handle when the operator attaches or removes the metal mask 100 to or from the workpiece or carries it in their hand. The eave portion 104 on the metal mask 100 facilitates attachment and removal of the metal mask 100 and prevents direct contact with the surface of the workpiece and the deposited film.

FIG. 1A and FIG. 1B show that the body 102 and the eave portion 104 configuring the metal mask 100 have different outer diameters. Specifically, an external diameter D2 of the eave portion 104 is larger than an external diameter D1 of the body 102. Due to this dimensional relationship, the metal mask 100 has a shape where the eave portion 104 protrudes from the body 102. A length P1 of the eave portion 104 protruding from the body 102 may be constant over the entire circumference or may vary in parts.

The external diameter D1 of the body 102 and the external diameter D2 of the eave portion 104 are set appropriately to suit the size of the workpiece, which is the masking object. As the eave portion 104 is projected outwards in relation to the body 102, the external diameter D1 and the external diameter D2 have the relationship D1 < D2. On the other hand, a height H1 of the body 102 and the length P1 of the protruding eave portion 104 are adjusted as appropriate, taking into account the thickness of the film to be deposited, the shape of the workpiece and the region where the film is to be formed, the conditions of the thermal spraying, and other factors.

The molten or softened material sprayed during thermal spraying is ideally sprayed from a direction that is perpendicular to the surface of the metal mask 100. When the metal mask 100 is attached to the workpiece, the area under the eave portion 104 is shaded and the sprayed molten or softened material acts to prevent a film from being deposited, although the film is formed with some thickness even in the shaded area of the eave portion 104 due to the run-off of the sprayed thermal spray material. When the length P1 of the eave portion 104 is sufficiently long, that is, when the protruding length P1 of the eave portion 104 is longer than the distance that the sprayed thermal spray material comes around the underside of the eave portion 104, the film can be prevented from being deposited on the sides of the body 102. In other words, the thickness of the film formed under the eave portion 104 by the thermal spraying process can be adjusted according to the length P1 of the protruding eave portion 104 and the height H1 of the body 102. For example, when the height H1 of the body 102 is changed while the length P1 of the eave portion 104 is kept constant, a larger height H1 can increase the depth to which the thermal spraying material can come around, while a smaller height H1 can relatively shorten the depth to which the thermal spraying material can come around. The height H1 of the body 102 needs to be larger than the film thickness of the film so that it is not embedded in the film deposited by the thermal spray process. Specifically, the height of the body 102 is to be 0.5 mm to 1.0 mm thicker than the film thickness of the film to be deposited. The length P1 of the protruding eave portion 104 is 0.5 mm to 10 mm, preferably 1 mm to 3 mm, taking into account the wraparound of the thermal spraying material.

The length P1 of the eave portion 104 protruding from the body 102 has the relationship P1 = 1/2 (D2 - D1). As the external diameter D2 of the eave portion 104 can be changed independently of the external diameter D1 of the body 102, the length P1 of the protruding eave portion 104 can be freely adjusted. As is apparent from the structure shown in FIG. 1B, the height H1 of the body 102 can also be set independently.

The size and shape of the metal mask 100 may be changed according to various shapes of the workpiece. Since the metal mask 100 shown in FIG. 1A and FIG. 1B has a disk-like shape, it may be applied when the masking portion of the workpiece is circular. When the masking area for the workpiece is rectangular, the shape of the metal mask 100 in a plan view can be changed accordingly.

The metal mask 100 may be applied to various thermal spraying materials. Metals, alloys, cermet, and ceramics are examples of thermal spray materials. In the thermal spray process, the thermal spray material is sprayed onto the workpiece, including the area to which the metal mask 100 is attached. The film formed on the surface of the workpiece by the thermal spray process is preferably firmly adhered, but it is preferable that the thermal spray material does not adhere to the surface of the metal mask 100 (it is difficult to adhere) or can be easily removed even if it does adhere to the surface of the metal mask 100. The metal mask 100 should have a heat resistance temperature that can withstand the temperature during thermal spraying.

In order for the metal mask 100 to meet these conditions, it is preferable that the body 102 and the eave portion 104 are made of metal, the body 102 and the eave portion 104 are formed of a resin material, or the body 102 and the eave portion 104 are made of metal and the surface is coated with a resin material. The resin material is preferably a fluoroplastic due to its heat resistance and the ease of removing the film formed by the thermal spraying process, for example, polytetrafluoroethylene (PTFE).

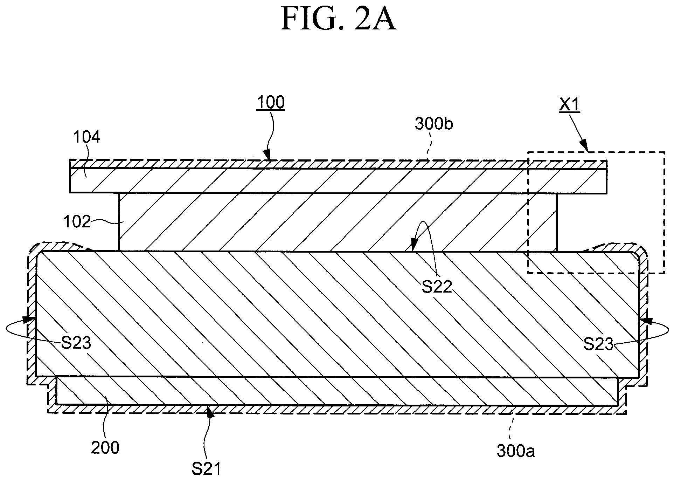

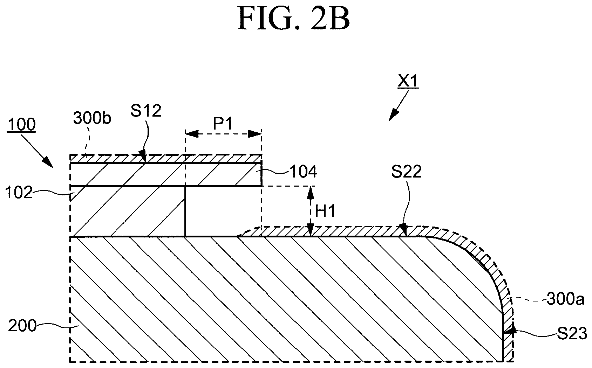

FIG. 2A and FIG. 2B show the metal mask 100 attached to a workpiece 200. FIG. 2A shows a cross-sectional view of the metal mask 100 and the workpiece 200, and FIG. 2B shows an enlarged view of the region X1 shown in FIG. 2A. The workpiece 200 shown in FIG. 2A and FIG. 2B represents a substrate stage that supports a semiconductor substrate or glass substrate in a semiconductor manufacturing apparatus, the metal mask 100 is attached to a second surface S22 of the workpiece 200, and a film 300a formed by thermal spraying is shown in dotted lines that covers a first surface S21, a third surface S23, and the periphery of the second surface S22.

The shape of the workpiece 200 which is illustrated is an example, and the workpiece to which the metal mask 100 of the present disclosure is applied is not limited to this shape. The workpiece 200 is not limited in shape as long as the metal mask 100 is attached to the area where the film is formed by thermal spraying.

As shown in FIG. 2A, the metal mask 100 is attached to the second surface S22 of the workpiece 200 on which the film is formed by thermal spraying. The metal mask 100 has the same shape as shown in FIG. 1A and FIG. 1B and is attached so that the inner portion of the second surface S22 of the workpiece 200 is masked and the periphery is exposed. The workpiece 200 is set in a rotating machine and the thermal spraying process is performed while rotating the workpiece 200. The metal mask 100 may be fixed by a vacuum chuck using the structure of the workpiece 200 or may be fastened by screws or other components. The metal mask 100 may also be attached to the workpiece 200 and a center of the metal mask 100 may be held from the top by a rotating mounting fixture.

As shown in the enlarged view in FIG. 2B, the film 300a formed by the thermal spraying process is formed from the third surface S23 to the periphery of the second surface S22 of the workpiece 200, as shown by the dotted line. The film 300a is also formed on the top surface of the metal mask 100. The metal mask 100 is arranged in contact with the second surface S22 of the workpiece 200, and the eave portion 104 protrudes from the body 102 with the length P1 in the direction of the periphery of the workpiece 200. The molten or softened thermal spray material sprayed in the thermal spray process is not deposited directly on the underside of the eave portion 104 because it is shaded, but a film 300a is formed to the inside of the eave portion 104 by a portion which comes around. A film 300b is also deposited on the top surface of the metal mask 100 (second surface S12). However, the film 300a on the side of the workpiece 200 and the film 300b on the side of the metal mask 100 are discontinuous because the eave portion 104 is lifted off the workpiece 200 by the height H1 of the body 102 of the metal mask 100. The film 300a and the film 300b are discontinuous due to the eave portion 104 protruding at the length P1.

The film 300a deposited under the eave portion 104 extends from the region overlapping an edge of the eave portion 104 to the region below the eave portion 300, but the length of the eave portion 104 is preferably set so that the film 300a does not reach the body 102. Although the film 300a deposited under the eave portion 104 may have a constant thickness, it is preferred that the thickness of the film 300a gradually decreases from the region overlapping the edge of the eave portion 104 towards the inside, as shown schematically in FIG. 2A and FIG. 2B. The gradual thinning of the film thickness of the film 300a at the edges can prevent peeling at the boundaries of the masking.

The film thickness of the film 300a formed by the thermal spraying process is around 100 µm to 1500 µm. It is preferable that the metal mask 100 attached to the surface of the workpiece 200 is sufficiently thicker than the film thickness of the film 300, as it becomes difficult to remove the metal mask 100 if it is embedded by the film 300 (300a, 300b).

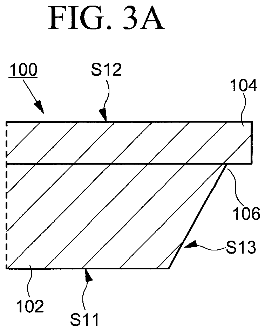

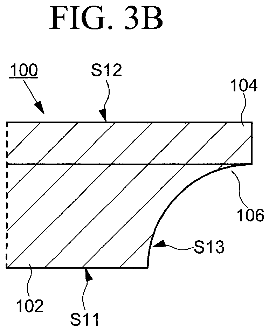

The shape of the eave portion 104 of the metal mask 100 is not limited to the shapes shown in FIG. 1A and FIG. 1B. For example, as shown in FIG. 3A, the third surface S13 of the metal mask 100 (side of the body 102) may have an inclined surface (tapered shape) that widens from the first surface S11 to the second surface S12. The inclined surface of the body 102 is discontinuously connected to the eave portion 104 to form the step portion 106 and to form a structure in which the eave portion 104 protrudes. It is possible to stabilize the shape of the eave portion 104 by the sloping surface of the body 102, thereby preventing deformation. As shown in FIG. 3B, the inclined surface of the body 102 may be formed with a curved surface.

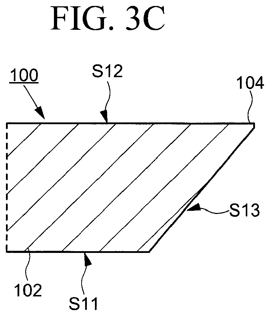

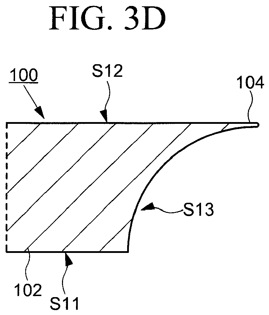

Furthermore, as shown in FIG. 3C, the sloping surface of the third surface S13 of the body 102 may be continuous from the first surface S11 to the second surface S12. The eave portion 104 may be formed by an edge of the second surface S12 protruding outwards with respect to an edge of the first surface S11. As shown in FIG. 3D, the inclined surface may have a curved surface shape.

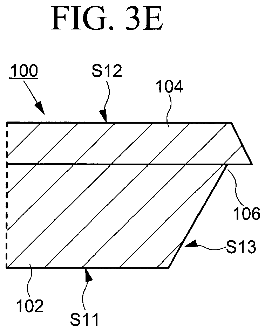

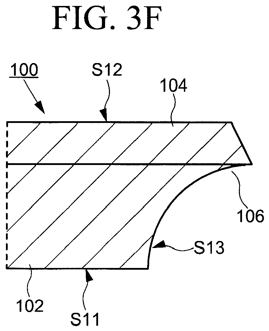

FIG. 3E and FIG. 3F have the same shape as FIG. 3A and FIG. 3B, but differ in that the sides of the eave portion 104 have a tapered shape that tapers inwards. It is possible to prevent the deposition of the sprayed film on the sides of the eave portion 104 while keeping the strength of the metal mask 100 during the thermal spraying process by having such a tapered shape of the edge of the eave portion 104. In the thermal spraying process, the thermal spray gun is not only directed from above the metal mask 100, but also from the side of the workpiece 200. In such a case, since the eave portion 104 of the metal mask 100 has a tapered shape, it is possible to prevent the film from being deposited on the side surface, and even if there is deposition on the side surface, the amount of the film can be reduced.

The metal mask 100 with the shape shown in FIG. 3A to FIG. 3F has an inclined portion in the body 102 and the eave portion 104 above this inclined portion, so that the film 300b deposited on the workpiece 200 and the film 300a deposited on the metal mask 100 are discontinuous.

As explained above, the metal mask 100 according to the present disclosure has the eave portion 104, so that the film 300a deposited on the workpiece 200 by the thermal spraying process and the film 300b deposited on the metal mask 100 can be discontinuous. Thereby, it is possible to avoid damaging the film 300a when the metal mask 100 is removed after the thermal spraying process. Therefore, cracks in the film 300a formed on the workpiece 200 and delamination at the boundary with the metal mask 100 can be prevented. It is thus possible to improve the quality of the workpiece 200 to which the thermal spraying treatment is applied.

### REFERENCES SIGNS LIST

- 100:: metal mask,
- 102:: body,
- 104:: eave portion,
- 106:: step portion,
- 200:: workpiece,
- 300:: film

## Claims

1. A metal mask, comprising:
a body having a first surface in contact with a surface of a workpiece, a second surface opposite the first surface and a third surface between the first surface and the second surface; and
an eave portion continuous from the body and projecting externally from the first surface,
wherein the eave portion is arranged away from the surface of the workpiece.

2. The metal mask according to claim 1, wherein the third surface includes a step portion forming the eave portion.

3. The metal mask according to claim 1, wherein the third surface has a sloping surface extending from the first surface towards the second surface, and the eave portion is arranged above the sloping surface.

4. The metal mask according to any one of claims 1 to 3, wherein the body and the eave portion are made of metal, the body and the eave portion are made of resin, or the body and the eave portion are made of metal and covered with resin on the surface.
